# FASCICULE DE BREVET EUROPEEN

(11) **EP 3 470 856 B1**
(45) Date de publication et mention de la délivrance du brevet: **24.08.2022**
(21) Numéro de dépôt: 18199604.2
(22) Date de dépôt: 10.10.2018
(51) Int. Cl.: G01R 31/52, H01H 83/14, H02H 3/33

(54) **MODULE DE DÉTECTION D'UN DÉFAUT ÉLECTRIQUE POUR UN ENSEMBLE DE PROTECTION ÉLECTRIQUE ET ENSEMBLE DE PROTECTION ÉLECTRIQUE COMPRENANT UN TEL MODULE DE DÉTECTION**
MODUL ZUR DETEKTION EINER ELEKTRISCHEN STÖRUNG FÜR EINE ELEKTRISCHE SCHUTZANORDNUNG, UND ELEKTRISCHE SCHUTZANORDNUNG, DIE EIN SOLCHES DETEKTIONSMODUL UMFASST
MODULE FOR DETECTING AN ELECTRICAL DEFECT FOR AN ELECTRICAL PROTECTION ASSEMBLY AND ELECTRICAL PROTECTION ASSEMBLY COMPRISING SUCH A DETECTION MODULE

(30) Priorité: 11.10.2017 FR 1759516
(43) Date de publication de la demande: 17.04.2019
(73) Titulaire: Schneider Electric Industries SAS, 92500 Rueil Malmaison (FR)
(72) Inventeur: TIAN, Simon, 38050 GRENOBLE Cedex 09 (FR); BURNOT, Claude, 38050 GRENOBLE Cedex 09 (FR); LEBEAU, Bernard, 38050 GRENOBLE Cedex 09 (FR); PUPIN, Thomas, 38050 GRENOBLE Cedex 09 (FR)
(74) Mandataire: Lavoix

(56) Documents cités:
- EP-A1- 0 456 585
- EP-A1- 0 818 798
- WO-A1-2009/089995
- US-A- 5 446 431
- US-A1- 2002 006 022
- US-B1- 6 191 589

## Description

La présente invention concerne un module de détection d'un défaut électrique pour un ensemble de protection électrique ainsi qu'un ensemble de protection électrique comprenant un appareil de coupure d'un courant électrique et un tel module de détection.

On connaît des ensembles de protection électrique formés d'un appareil de coupure d'un courant électrique, tel qu'un disjoncteur, qui est associé à un ou plusieurs modules de détection chacun capable de détecter un défaut électrique au sein d'une ligne d'alimentation électrique. De tels ensembles sont généralement montés sur un tableau électrique afin d'assurer la protection d'une installation électrique.

Typiquement, chaque module de détection est configuré pour détecter un type spécifique de défaut électrique et pour commander en conséquence le déclenchement de l'appareil de coupure. Ainsi, pour assurer une protection efficace de l'installation électrique, l'ensemble de protection comporte plusieurs modules de détection qui sont associés et couplés à l'appareil de coupure.

Par exemple, un module de détection, dit différentiel, est configuré pour détecter la présence d'un courant électrique résiduel sur une ligne électrique d'alimentation. Un autre module de détection est adapté pour détecter la présence d'un arc électrique sur une ligne électrique d'alimentation.

Une telle configuration a cependant pour inconvénient de nécessiter un encombrement important, puisqu'il faut utiliser, pour chaque phase de la ligne d'alimentation électrique, autant de modules que de types de défauts contre lesquels on veut se prémunir.

Cela pose un problème dans les cas où le tableau électrique n'offre pas suffisamment de place pour accueillir plusieurs modules de détection, par exemple dans le cas d'installations industrielles comportant un grand nombre de lignes d'alimentation électriques, ou encore lorsqu'on modernise une installation existante sans pouvoir agrandir à volonté le tableau électrique. Dans ce cas, souvent, faute de place, certains modules de protection ne sont pas installés, de sorte que l'ensemble de protection n'offre alors pas de protection contre certains types de défauts électriques.

Cela complique aussi le raccordement de l'ensemble de protection aux lignes électriques d'alimentation lorsque le tableau électrique est équipé de peignes de raccordement dont les connecteurs sont agencés avec un pas d'espacement fixe.

Les documents US 2002/006022 A1, US 6191589 B1 et WO 2009/089995 A1 décrivent des exemples de modules de détection d'un défaut électrique.

C'est à ces inconvénients qu'entend plus particulièrement remédier l'invention en proposant un module de détection d'un défaut électrique capable d'intégrer plusieurs fonctions de détection de défauts électriques de nature différente, tout en présentant une forme compacte avec un encombrement et des dimensions qui sont compatibles avec les installations existantes.

A cet effet, l'invention concerne un module de détection d'un défaut électrique pour un ensemble de protection comme défini dans la revendication indépendante 1.

Grâce à l'invention, le module de détection est capable de détecter des défauts électriques de nature différente en utilisant des composants logés dans un boîtier compact, par exemple ayant un facteur de forme spécifique. Il n'est pas nécessaire, comme c'est le cas dans les ensembles de protection connus, d'utiliser un module de détection pour chaque type de défaut électrique. Cela réduit donc l'encombrement de l'ensemble de protection.

Selon des aspects avantageux mais non obligatoires de l'invention, un tel module de détection peut incorporer une ou plusieurs des caractéristiques suivantes, prises isolément ou suivant toute combinaison techniquement admissible :
- Le rapport de la longueur du premier tore de mesure sur le diamètre du premier tore de mesure est supérieur ou égal à 1, de préférence supérieur ou égal à 1,5.
- Le circuit électronique de traitement comporte au moins une carte électronique, et en ce que le relais présente une forme aplatie avec une épaisseur inférieure ou égale à 12mm, le relais étant fixé sur ladite carte électronique.
- Le circuit électronique de traitement comprend également une carte électronique additionnelle superposée avec l'autre carte électronique, le relais étant intercalé entre les cartes électroniques en étant placé au contact de ces cartes électroniques.
- La largeur du module de détection est égale à 18mm.
- La longueur du premier tore de mesure, mesurée selon l'axe longitudinal, est comprise entre 15mm et 50mm.
- Le premier tore de mesure comporte, disposés de façon coaxiale, un passage central creux, un cœur magnétique torique entourant le passage central creux, un premier boîtier qui entoure le cœur magnétique, une bobine formée par un enroulement d'un fil conducteur autour du premier boîtier, et un deuxième boîtier qui recouvre au moins partiellement la bobine.
- Le premier tore de mesure est connecté à une carte électronique du circuit électronique de traitement et le deuxième boîtier du premier tore de mesure comporte une patte de maintien en forme de languette, ladite carte électronique comportant un évidement de forme complémentaire à la patte de maintien, la patte de maintien étant reçue dans cet évidement.

Selon un autre aspect, l'invention concerne un ensemble de protection électrique comprenant un appareil de coupure d'un courant électrique et un module de détection d'au moins un défaut électrique, ce module de détection étant associé à l'appareil de coupure et étant destiné à commander le déclenchement de cet appareil de coupure, cet ensemble de protection électrique étant caractérisé en ce que le module de détection est tel que décrit précédemment.

Selon des aspects avantageux mais non obligatoires de l'invention, un tel ensemble de protection électrique peut incorporer une ou plusieurs des caractéristiques suivantes, prises isolément ou suivant toute combinaison techniquement admissible :
- Le boîtier est commun au module de détection et à l'appareil de coupure.
- L'appareil de coupure comporte un boîtier additionnel distinct du boîtier du module de détection, l'appareil de coupure et le module de détection étant dissociables l'un de l'autre.

L'invention sera mieux comprise et d'autres avantages de celle-ci apparaîtront plus clairement à la lumière de la description qui va suivre, d'un mode de réalisation d'un module de détection donné uniquement à titre d'exemple et faite en référence aux dessins annexés dans lesquels :
- la figure 1 est une représentation schématique d'un ensemble de protection électrique comprenant un module de détection selon un mode de réalisation de l'invention ;
- la figure 2 est une représentation schématique du module de détection de l'ensemble de la figure 1, selon une vue en coupe longitudinale ;
- la figure 3 est une représentation schématique du module de détection de la figure 2, selon une vue en perspective ;
- la figure 4 est une représentation schématique du module de détection de la figure 3, selon une vue en perspective, dans laquelle des premier et deuxième tores de mesure sont illustrés dans une vue écorchée ;
- la figure 5 est une représentation schématique d'une vue en coupe des premier et deuxième tores de mesure de la figure 4 ;
- la figure 6 est une représentation schématique du module de détection de la figure 3, selon une vue en perspective opposée ;
- les figures 7 et 8 sont des représentations schématiques d'un tore de mesure de courant appartenant au dispositif de protection des figures 2 à 5, respectivement illustrées selon une vue isométrique et selon une vue éclatée ;
- la figure 9 est une représentation schématique d'un ensemble de protection électrique selon un deuxième mode de réalisation de l'invention ;
- la figure 10 est une représentation schématique d'un ensemble de protection électrique selon un troisième mode de réalisation de l'invention ;
- la figure 11 est une représentation schématique d'un ensemble de protection électrique selon un quatrième mode de réalisation de l'invention ;
- la figure 12 est une représentation schématique d'un ensemble de protection électrique selon un cinquième mode de réalisation de l'invention.

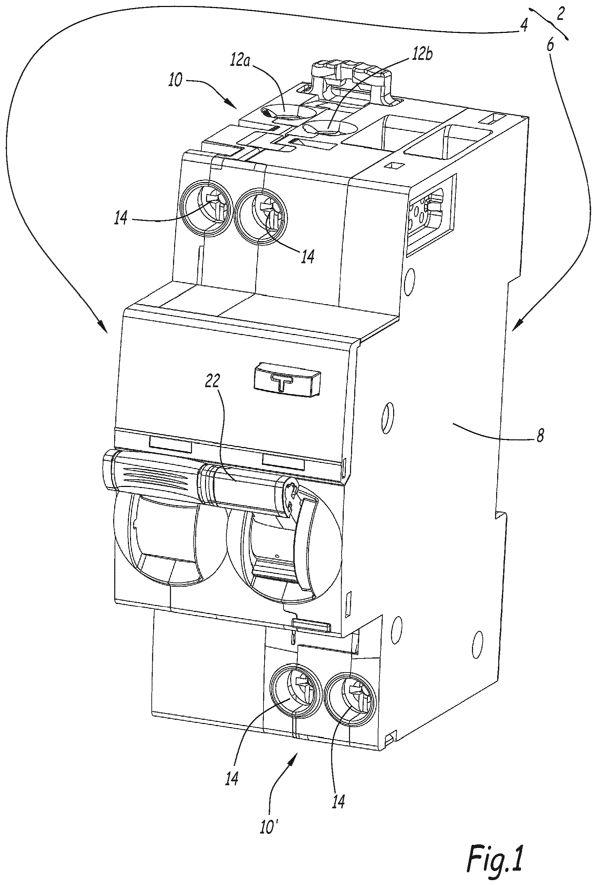

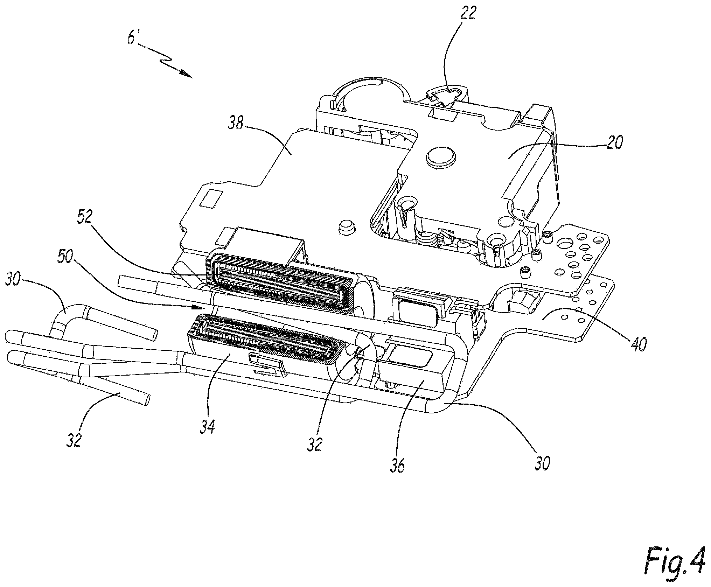

Les figures 1 à 6 représentent un ensemble de protection 2 selon un premier mode de réalisation de l'invention. L'ensemble 2 comprend un appareil de coupure 4 d'un courant électrique, tel qu'un disjoncteur ou un sectionneur ou un interrupteur, et un module de détection 6 d'un défaut électrique.

L'ensemble 2 est destiné à être raccordé électriquement à une ligne d'alimentation électrique, en vue d'assurer la protection d'une installation électrique. En particulier, l'ensemble 2 est ici destiné à être monté au sein d'un tableau électrique.

Dans cet exemple, la ligne d'alimentation électrique comprend un premier conducteur de ligne et un second conducteur de ligne adaptés pour acheminer un courant électrique. On comprend donc que ces conducteurs de ligne sont extérieurs à l'ensemble 2 et sont destinés à être raccordés électriquement à celui-ci.

Dans cet exemple illustratif, la ligne d'alimentation électrique transporte un courant électrique monophasé, de sorte que les premier et deuxième conducteurs de ligne sont, respectivement, un conducteur de phase et un conducteur de neutre.

En variante, toutefois, la ligne d'alimentation électrique peut servir à acheminer des courants continus, l'ensemble 2 étant alors destiné à fonctionner dans une installation électrique à courant continu. Les termes « conducteur de phase » et « conducteur de neutre » correspondent à un exemple illustratif et les modes de réalisation décrits ci-dessous sont applicables au cas d'une installation à courant continu. Les premier et deuxième conducteurs de ligne peuvent ainsi être associés à autre chose qu'une phase et qu'un neutre, respectivement.

L'appareil 4 est adapté pour commuter entre un état ouvert, empêchant la circulation du courant sur la ligne d'alimentation, et un état fermé, autorisant la circulation du courant sur cette ligne d'alimentation. De façon connue, cette commutation est par exemple mise en oeuvre au moyen de contacts électriques séparables.

Le module 6 est configuré pour détecter un défaut électrique sur la ligne d'alimentation et, en réponse, déclencher la commutation de l'appareil 4 de son état fermé vers son état ouvert. Pour ce faire, le module 6 est couplé à l'appareil 4, par exemple de façon mécanique, comme expliqué ci-après.

Le module 6 est ici configuré pour détecter deux types de défauts électriques : un défaut de courant résiduel, aussi dit défaut différentiel et un défaut de type arc électrique.

Le défaut différentiel correspond ici à la présence anormale d'une différence d'intensité du courant entre les lignes de phase et de neutre d'une même ligne d'alimentation électrique.

Le défaut d'arc électrique correspond ici à une forme particulière du courant électrique dans la ligne de phase due à l'apparition d'un arc électrique dans la ligne d'alimentation électrique, qui forme ainsi une signature spécifique. Cette signature correspond ainsi à un signal d'arc électrique.

De fait, le module 6 est ici dit être un module de détection multifonctions.

Le module 6 comporte ici un boîtier 8 de protection, tel qu'un boîtier moulé, réalisé de préférence en un polymère rigide, par exemple en matière plastique. Dans ce qui suit, les composants assurant le fonctionnement du module 6 sont collectivement désignés par la référence 6'. Ces composants 6' sont logés à l'intérieur du boîtier 8.

Dans ce mode de réalisation, le boîtier 8 est commun au module 6 et à l'appareil 4. Avantageusement, les composants respectifs de l'appareil 4 et du module 6 sont alors logés dans des zones distinctes à l'intérieur du boîtier 8, de préférence dans deux compartiments séparés du boîtier 8. En variante, l'appareil 4 et le module 6 peuvent être logés dans deux boîtiers différents qui sont ensuite accolés entre eux, l'appareil 4 et le module 6 étant alors dissociables l'un de l'autre.

La largeur du module 6 est ici égale à 18mm.

On note L2 la largeur de l'ensemble 2. La largeur L2 est ici égale à 36mm. Cette largeur L2 est ici mesurée sur une face de l'ensemble 2, suivant une direction perpendiculaire à des faces latérales extérieures de l'ensemble 2. Ici, comme le boîtier 8 est commun, la largeur L2 correspond à la largeur de ce boîtier 8 et la largeur du module 6 est égale à la moitié de la largeur L2.

Ainsi, l'ensemble 2 est compatible avec des tableaux électriques connus pourvus de logements standardisés présentant chacun une largeur de 18mm. L'élément 2 occupe alors deux tels logements lorsqu'il est monté sur un tel tableau électrique.

Afin d'assurer son raccordement à la ligne d'alimentation électrique, l'ensemble 2 comprend une première zone de raccordement 10 et une deuxième zone de raccordement 10'. Par exemple, la première zone 10 correspond à une entrée et la deuxième zone 10' correspond à une sortie de l'ensemble 2.

Dans ce mode de réalisation, la zone 10 est ménagée au niveau de l'appareil 4 et la zone 10' est ménagée au niveau du module 6, ici sur des faces, respectivement, supérieure et inférieure de l'ensemble 2. Un dispositif d'interconnexion électrique interne à l'ensemble 2, non illustré, permet de raccorder électriquement les composants de l'appareil 4 à ceux du module 6.

La zone 10 comprend deux terminaux de raccordement 12a et 12b, respectivement aptes à accueillir des conducteurs correspondants de la ligne de phase et de la ligne de neutre. Ces terminaux 12a et 12b sont ici disposés dans un orifice ménagé dans la paroi correspondante du boîtier 8. Par exemple, ces trous sont disposés côte à côte en étant décalés selon une direction perpendiculaire à la face avant du boîtier 8.

Des vis 14 accessibles depuis la face avant de l'ensemble 2 permettent de fixer ces conducteurs aux terminaux de raccordement 12a et 12b.

De façon analogue, la zone 10' est ici pourvue de terminaux de raccordement analogues aux terminaux 12a, 12b et qui ne sont pas illustrés ici.

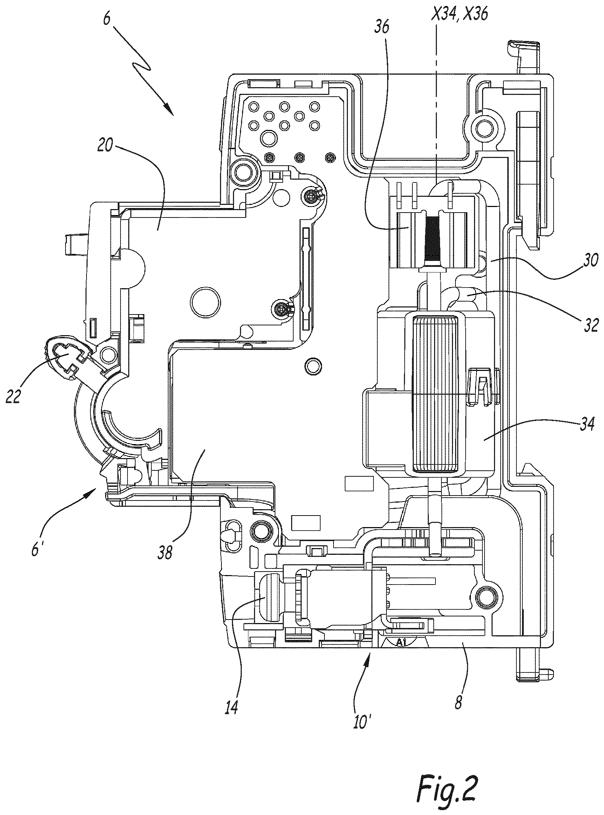

Comme illustré aux figures 2 à 5, le module 6 comporte un mécanisme de déclenchement 20, ici pourvu d'un levier de commande 22 et d'un organe de couplage mécanique 24.

Le levier 22 est de préférence accessible depuis l'extérieur du boîtier 8, par exemple pour être manipulé par un opérateur.

L'organe 24 coopère avec l'appareil 4 de manière à provoquer sa commutation entre les états ouvert et fermé en fonction de l'état du mécanisme 20.

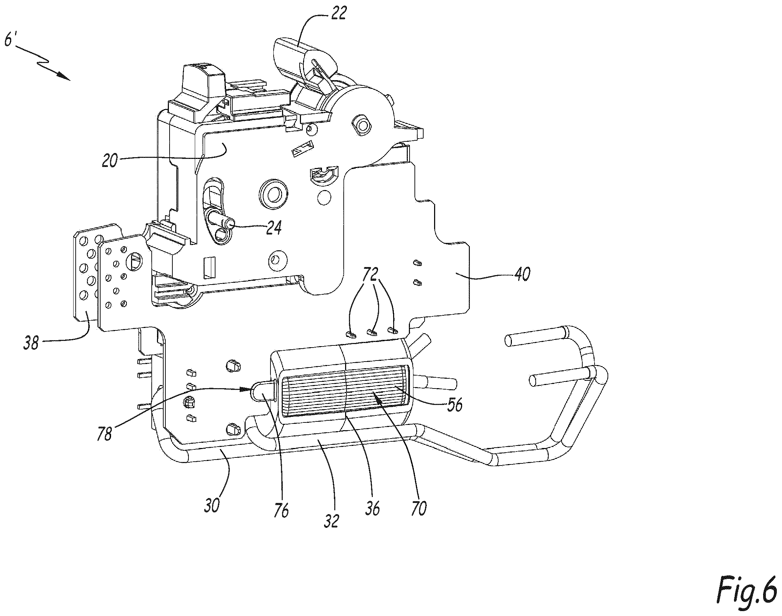

Dans cet exemple, comme cela ressort plus particulièrement de la figure 6, l'organe 24 se présente sous la forme d'un plot mobile qui coopère avec un organe mécanique correspondant à l'intérieur de l'appareil 4. Par exemple, lorsque l'appareil 4 est un disjoncteur, alors l'organe 24 coopère avec un mécanisme de déclenchement de ce disjoncteur.

Le module 6 comprend également un premier conducteur interne de ligne 30, un deuxième conducteur interne de ligne 32, un premier tore de mesure 34 de courant et un deuxième tore de mesure 36 de courant, ainsi qu'un circuit électronique de traitement.

Dans cet exemple, les conducteurs 30 et 32 sont internes au module 6 et sont distincts des conducteurs de ligne de la ligne d'alimentation électrique.

Dans ce mode de réalisation, le conducteur 30 est un conducteur de phase et le conducteur 32 est un conducteur de neutre. Les conducteurs 30 et 32 peuvent, en variante, être associés à autre chose qu'une phase et qu'un neutre, respectivement, notamment lorsque les courants sont des courants continus.

Les conducteurs 30 et 32 sont, par exemple, chacun réalisé en un matériau électriquement conducteur, tel du cuivre, par exemple sous la forme d'un fil rigide. Ces conducteurs présentent ici chacun un diamètre supérieur ou égal à 2mm ou à 2,35mm, permettant ici d'obtenir un calibre de 40 Ampères.

Le conducteur de phase 30 et le conducteur de neutre 32 sont connectés à des terminaux de raccordement correspondants de l'ensemble 2. Dans cet exemple, les conducteurs 30 et 32 présentent une de leurs extrémités qui est raccordée aux terminaux correspondants de la zone 10', et leur extrémité opposée qui est raccordée aux composants de l'appareil 4.

Les tores de mesure 34 et 36 sont ici des tores magnétiques de mesure de courant.

Les tores de mesure 34 et 36 sont disposés chacun selon un axe longitudinal.

Le tore 34 a une forme tubulaire allongée avec un circuit magnétique important pour permettre un fonctionnement de la protection différentielle à propre courant. L'expression « à propre courant » signifie ici que le tore 34 est auto-alimenté électriquement, c'est-à-dire qu'en cas de défaut différentiel entre les conducteurs 30 et 32, le tore 34 est apte à générer un signal de détection de défaut à partir de courants induits générés par les courants électriques qui circulent dans les conducteurs 30 et 32. Ainsi, cette fonction ne nécessite pas d'alimentation auxiliaire.

Le tore 36 sert à la détection d'arc électrique. Par exemple, il présente une forme tubulaire aplatie, dite en galette. Le tore 36 est ici plus petit mais fonctionne avec un traitement complexe et une carte électronique alimentée.

On note « X34 » l'axe longitudinal du premier tore 34 et on note « X36 » l'axe longitudinal du deuxième tore 36.

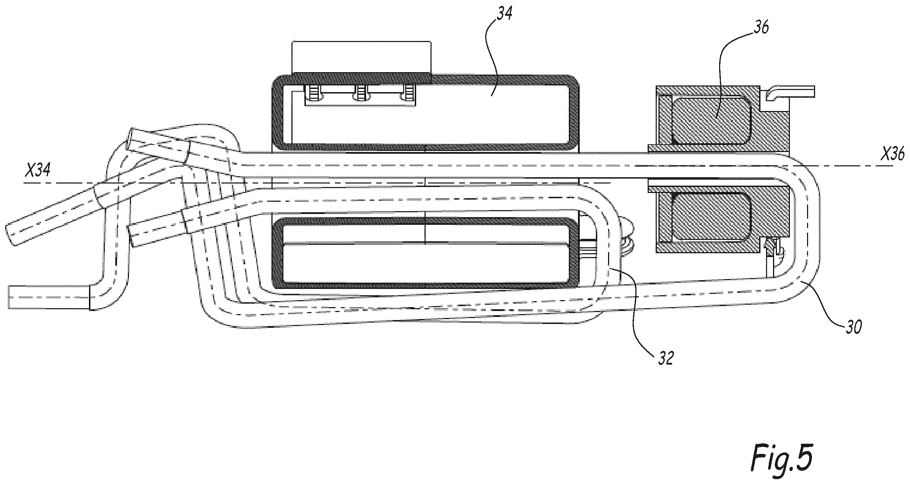

Les tores de mesure 34 et 36 sont parallèles et alignés entre eux. De préférence, malgré leur alignement, les tores 34 et 36 sont légèrement désaxés l'un par rapport à l'autre, comme cela ressort plus particulièrement de la figure 5. En d'autres termes, les axes X34 et X36 sont parallèles mais pas confondus entre eux. Ils sont décalés d'une faible distance, par exemple inférieure à 10mm ou inférieure à 5mm. De préférence, par exemple, le conducteur 30 est centré sur l'axe X36 et les conducteurs 30 et 32 sont disposés de part et d'autre de l'axe X34. Ainsi, les tores 34 et 36 sont ici essentiellement alignés autour du conducteur 30. Cela facilite le passage des conducteurs 30 et 32 et diminue l'encombrement des tores 34 et 36.

Le premier tore de mesure 34 est disposé autour du conducteur de phase 30 et du conducteur de neutre 32. A cet effet, les conducteurs 30 et 32 ont chacun une portion qui est reçue dans un passage central 50 creux du premier tore 34, ces parties étant disposées de façon essentiellement parallèle l'une avec l'autre au niveau de ce passage central 50, en étant ici alignées parallèlement à l'axe longitudinal X34.

Le premier tore 34 est adapté pour mesurer une différence de courant électrique circulant entre ces conducteurs 30 et 32.

De façon connue, en présence d'un défaut électrique causé par un courant de fuite dans l'installation électrique au niveau de la ligne d'alimentation électrique, le courant électrique qui circule dans la ligne de neutre présente une intensité différente du courant qui circule dans la ligne de phase associée, alors que normalement les deux courants devraient présenter une même intensité.

Ainsi, dans un cas normal, en l'absence d'un tel défaut, le courant qui circule dans le conducteur de neutre 32 présente une même intensité que celui qui circule dans le conducteur de phase 30, mais circule avec un sens opposé. Les champs magnétiques générés par ces courants circulant en sens opposés s'annulent donc au niveau du premier tore 34, de sorte que le flux magnétique total mesuré par le premier tore 34 est nul. Dans le cas où un tel défaut est présent, alors les champs magnétiques ne se compensent pas et le premier tore 34 détecte un flux total non nul.

Le premier tore 34 permet donc de détecter la présence d'un courant résiduel, et permet ainsi à l'ensemble 2 d'implémenter une fonction de protection différentielle à propre courant. En particulier, le signal de détection émis par le tore 34 est ici suffisant pour déclencher la commutation du relais 42 décrit ci-après. Ainsi, la fonction protection différentielle à propre courant ne nécessite pas d'alimentation extérieure mais à besoin d'un tore 34 de taille suffisante pour commander l'actionnement du relais.

Le deuxième tore de mesure 36 est quant à lui disposé autour du conducteur de phase 30, pour mesurer un courant électrique circulant dans ce conducteur 30.

A cet effet, le conducteur 30 est reçu dans un passage central creux du deuxième tore 36, mais ici le conducteur de neutre 32 n'est pas reçu à l'intérieur de ce passage central creux. Par exemple, le conducteur 32 présente une forme recourbée.

Le deuxième tore 36 permet quant à lui de mesurer une signature caractéristique d'un défaut d'arc électrique dans le courant de ligne qui circule dans le conducteur 30, cette signature correspondant ici à un signal représentatif d'arcs électriques particuliers, et permet donc à l'ensemble 2 d'implémenter une fonction de protection contre des arcs électriques.

Le circuit électronique de traitement est programmé pour recueillir les signaux de mesure de courant fournis par les tores de mesure 34 et 36, et pour déterminer automatiquement la présence d'un défaut électronique en fonction de ces signaux de mesure.

Le circuit électronique de traitement comporte au moins une carte électronique, de préférence deux cartes électroniques, servant de support à des composants électroniques permettant le traitement des signaux mesurés. A titre d'exemple illustratif, ces composants incluent une unité logique de calcul et/ou un ou plusieurs comparateurs numériques ou analogiques ainsi qu'un circuit d'alimentation électrique. Le circuit électronique peut aussi comporter un module de puissance, adapté pour fournir une alimentation électrique régulée à partir d'une source d'alimentation extérieure. Par exemple, cette alimentation régulée est destinée à alimenter électriquement les composants de traitement et le tore 36.

Le circuit électronique de traitement comprend ici une première carte électronique 38 et une deuxième carte électronique 40. Dans cet exemple illustratif, la carte 38 est une carte de traitement et comporte les composants de traitement associés, et la carte 40 est une carte d'alimentation électrique et comporte le module de puissance.

Les première et deuxième cartes électroniques 38, 40 sont ici disposées en parallèle et superposées l'une avec l'autre. Par exemple, les première et deuxième cartes électroniques 38, 40 sont disposées parallèlement aux parois latérales du boîtier 8.

Les première et deuxième cartes électroniques 38, 40 sont ici formées à partir de supports rigides de type PCB en résine époxyde sur lesquels sont ménagées des pistes électriquement conductrices et sur lesquels sont montés les composants électroniques. De préférence, elles présentent une forme semblable l'une avec l'autre.

Les tores de mesure 34 et 36 sont ici avantageusement logés au niveau d'une découpe ménagée sur un bord inférieur de ces cartes électroniques 38 et 40. Dans cet exemple, le tore 34 est disposé entre le tore 36 et la deuxième zone 10'.

Le module 6 inclut un relais électromécanique 42 de déclenchement, qui est connecté au circuit électronique de traitement et qui est couplé mécaniquement au mécanisme 20.

Le relais 42 est capable de commuter entre plusieurs états distincts, par exemple au moins deux états.

Le circuit électronique de traitement est programmé pour déclencher le relais 42 lorsqu'il détecte un défaut électrique à partir des signaux de mesure fournis par l'un ou l'autre du premier tore 34 et du deuxième tore 36, voire des deux tores de mesure 34 et 36.

Lorsque le relais 42 commute d'un premier état vers un deuxième état, il modifie l'état du mécanisme 20, ce qui entraîne une commutation de l'appareil de coupure 4, ici par l'intermédiaire de l'organe 24. En d'autres termes, ici, le mécanisme 20 sert à amplifier le mouvement et à transmettre un changement d'état à destination de l'appareil de coupure 4. Ainsi, le module 6 commande ici l'appareil 4 par l'intermédiaire du relais 42 de déclenchement et du mécanisme 20.

Le relais 42 présente avantageusement des dimensions réduites.

De préférence, le relais 42 présente une forme aplatie, par exemple une forme de pavé dont la base présente une forme essentiellement rectangulaire.

L'épaisseur E42 du relais 42 est inférieure ou égale à 12mm ou, de préférence, inférieure ou égale à 10mm et, de préférence encore, inférieure ou égale à 8,5mm. L'épaisseur E42 est ici égale à 8,3mm.

Par exemple, le relais 42 est fixé et connecté électriquement sur une des cartes électroniques 38, 40 en étant couché sur cette carte électronique, de sorte que la direction suivant laquelle l'épaisseur E42 est mesurée soit essentiellement perpendiculaire à cette carte électronique.

Dans cet exemple, le relais 42 est disposé entre les première et deuxième cartes électroniques 38, 40, de préférence en étant placé au contact de ces première et deuxième cartes électroniques 38, 40. L'écartement entre les première et deuxième cartes électroniques 38, 40 est alors adapté en conséquence.

Les cartes électroniques 38, 40 et le relais 42 sont ici disposés dans une zone centrale du boîtier 8, entre le mécanisme 20 d'une part et les tores 34, 36 d'autre part.

Le premier tore 34 présente ici une forme tubulaire allongée suivant l'axe longitudinal X34. Dans cet exemple, le premier tore 34 présente une forme essentiellement cylindrique d'axe directeur coïncidant avec l'axe longitudinal X34.

On note « L34 » la longueur du premier tore 34, ici mesurée parallèlement à l'axe longitudinal X34. La longueur L34 est de préférence comprise entre 15mm et 50mm.

On note « D56 » le diamètre du premier tore 34.

De façon avantageuse, le rapport de la longueur L34 sur le diamètre D34 est supérieur ou égal à 1, et de préférence supérieur ou égal à 1,5 ou, de préférence encore, supérieur ou égal à 2.

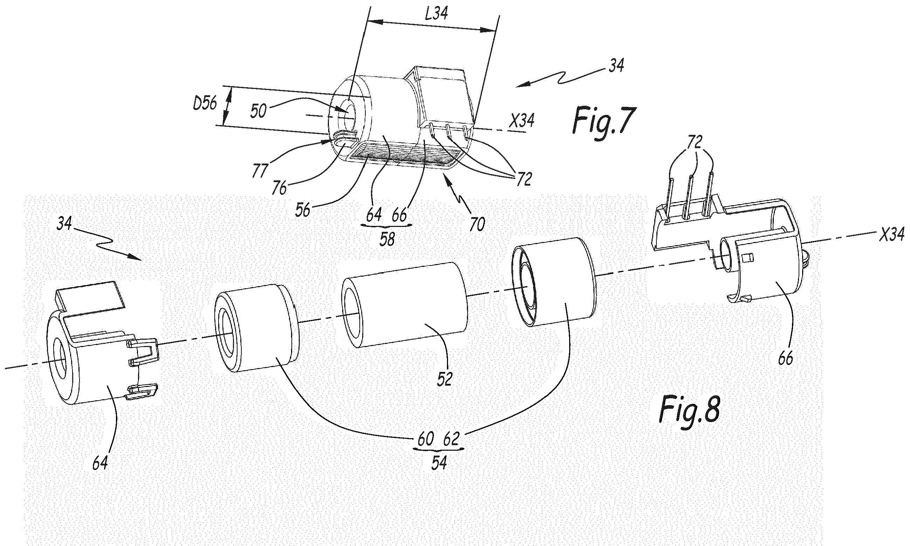

Comme illustré aux figures 7 et 8, le premier tore 34 comporte, disposés de façon coaxiale autour de l'axe longitudinal X34, le passage central 50 creux précédemment décrit, un cœur magnétique 52 torique entourant le passage central 50, un premier boîtier 54 qui entoure le cœur magnétique 52, une bobine 56 formée par un enroulement d'un fil conducteur autour du premier boîtier 54, et un deuxième boîtier 58 qui recouvre au moins partiellement la bobine 56.

Le diamètre D56 est ici mesuré sur le pourtour extérieur de la bobine 56.

Le cœur magnétique 52 présente ici une forme torique et est réalisé en un matériau magnétique, par exemple un matériau nanocristallin.

Le premier boîtier 54 est ici réalisé en un matériau rigide et amagnétique, par exemple du plastique. Il en va ici de même pour le deuxième boîtier 58.

Dans cet exemple, le premier boîtier 54 est formé par assemblage de deux demi-coques 60, 62. De façon analogue, le deuxième boîtier 58 est ici formé par assemblage de deux demi-coques 64, 66. En variante, les boîtiers 54 et/ou 58 peuvent être réalisés différemment.

Avantageusement, le deuxième boîtier 58 est pourvu d'au moins une fenêtre 70 oblongue qui s'étend longitudinalement parallèlement à l'axe longitudinal X34 et qui expose au moins partiellement la bobine 56.

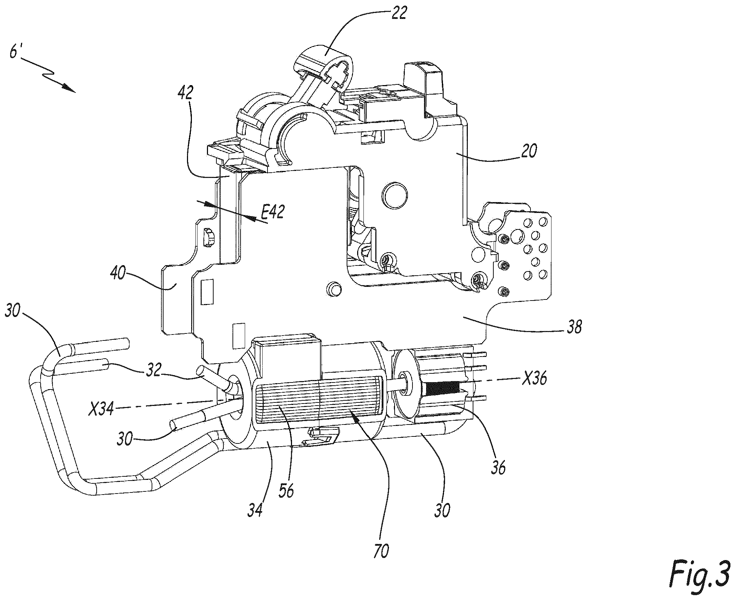

Plus précisément, la bobine 56 et ici formée par enroulement d'un fil conducteur autour du premier boîtier 54 de manière à former plusieurs spires disposées radialement par rapport à l'axe longitudinal X34 et espacées les unes des autres, ce fil s'étendant parallèlement à l'axe directeur X34, comme cela apparaît notamment sur les figures 2 et 3.

En particulier, de façon avantageuse, il n'est pas nécessaire ici de réaliser plusieurs tours de conducteurs de phase et de neutre, comme cela est le cas dans les tores de mesure connus en forme d'anneau ou de galette. La fragilité de la bobine 56 est ainsi réduite, et il n'est alors pas nécessaire d'utiliser un troisième boîtier de protection extérieur, enveloppant le deuxième boîtier 58, contrairement à ce qui est habituellement nécessaire dans les tores de mesure connus en forme d'anneau ou de galette. Grâce à cela, le premier tore 34 est plus compact.

Dans cet exemple, le premier tore 34 est monté sur la carte électronique 40.

Le premier tore 34 comporte des plots de connexion électrique 72 qui sont connectés par soudure à la carte électronique 40. Ces plots 72 sont ici raccordés aux extrémités de la bobine 56 et permettent d'envoyer, vers le circuit électronique de traitement, le signal mesuré par le premier tore 34.

Avantageusement, le deuxième boîtier 58 du premier tore 34 comporte une patte de maintien 76 en forme de languette, ici de forme arrondie. La carte électronique 40 comporte un évidement 78 de forme complémentaire à la patte de maintien 76, la patte de maintien 76 étant reçue dans cet évidement 78.

La patte de maintien 76 comporte ici une gorge 77 formée sur son pourtour et délimitée par des bords d'extrémité. Cette gorge 77 reçoit un bord de la carte électronique 40 lorsque le premier tore 34 est en configuration montée sur la deuxième carte électronique 40.

La patte de maintien 76 permet d'assurer une reprise de l'effort mécanique exercé par le premier tore 34 sur la carte électronique 40 qui lui sert de support, et évite notamment que ces efforts mécaniques ne soient exclusivement supportés par les plots de connexion 72, ce qui risquerait de les endommager, car ils sont principalement dimensionnés pour assurer une connexion électrique et non pas pour supporter une charge mécanique.

Grâce à l'invention, le module 2 est capable de détecter des défauts électriques de nature différente en utilisant un même ensemble de composants 6'. On dit alors que le module 2 assure une protection duale. Il n'est pas nécessaire, comme c'est le cas dans les ensembles de protection connus, d'utiliser un module de détection propre à chaque type de défaut électrique. Cela réduit donc l'encombrement de l'ensemble de protection 2, notamment au sein d'un tableau électrique. Cela réduit également son coût.

En particulier, du fait que la largeur du module 6 est ici égale à 18mm et que la largeur L2 est égale à 36mm, l'ensemble 2 peut être installé dans des tableaux électriques existant comportant des logements de taille standardisée à 18mm. Cela est particulièrement avantageux lorsque l'ensemble 2 est installé sur des installations existantes, par exemple lors d'opérations de modernisation, dites de « rétrofit ».

En outre, lorsque l'ensemble 2 doit être monté sur un tableau électrique équipé de peignes de connexion, grâce à l'encombrement réduit, il est plus facile d'installer et de connecter cet ensemble 2 qu'un ensemble classique comprenant plusieurs modules de détection. Là encore, cela facilite l'utilisation de l'ensemble 2 sur des installations existantes, par exemple lors d'opérations de « rétrofit ».

De plus, le choix des composants 6' et leur agencement à l'intérieur du boîtier 8 permettent de réduire l'encombrement du module 6.

Cela est en particulier réalisé grâce au premier tore 34, notamment de par sa forme et son agencement dans le module 6. Les tores connus présentent typiquement une forme d'anneau ou de galette et doivent être fixés sur une des cartes électroniques, perpendiculairement à celle-ci, ce qui cause un encombrement élevé à cause de leur facteur de forme. De plus, dans de tels tores connus, la bobine est nécessairement réalisée en enroulant plusieurs fois le fil autour d'une même armature, de façon à superposer plusieurs couches de spires. Or, une telle disposition accroît la fragilité de la bobine, ce qui nécessite l'utilisation d'un boîtier de protection plus résistant et donc plus encombrant.

Le fait d'utiliser deux cartes électroniques 38, 40 superposées permet ici de loger tous les composants électroniques nécessaires pour le traitement des signaux de mesure et assurer la détection des différents défauts électriques, le tout dans un volume réduit par rapport au cas où on utiliserait une unique carte électronique de superficie et de dimensions supérieures.

Cette miniaturisation est également obtenue grâce à la taille réduite du relais 42, et notamment son épaisseur E42, ainsi qu'à son agencement dans le module 6.

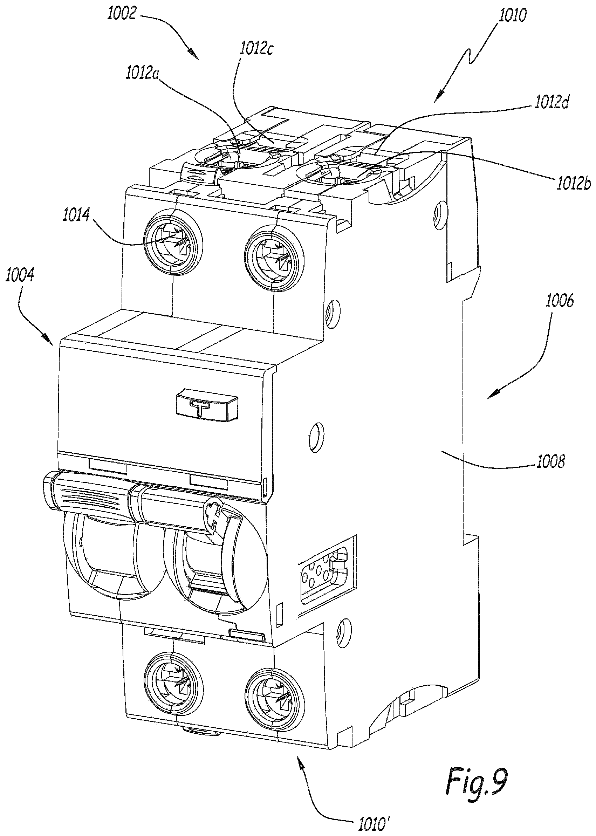

La figure 9 représente ensemble de protection 1002 selon un deuxième mode de réalisation de l'invention. Les éléments du module de détection de ce mode de réalisation qui sont analogues à l'ensemble de protection 2 du premier mode de réalisation portent les mêmes références numériques, incrémentées de la valeur 1000. Ces éléments ne sont pas décrits en détail, dans la mesure où la description ci-dessus peut leur être transposée. En particulier, tout ce qui est décrit ci-dessus en référence au fonctionnement du module 6 et à ses composants 6' s'applique ici au module 1006.

L'ensemble 1002 diffère notamment de l'ensemble 2 par la forme et l'agencement des zones de raccordement 1010 et 1010'.

Ici, la zone 1010 comporte deux terminaux de raccordement 1012a et 1012c disposés au niveau de l'appareil 4 et associés à une même vis de fixation 1014, et deux terminaux de raccordement 1012b et 1012d disposés au niveau du module 1006 et associés à une même autre vis de fixation 1014.

Un conducteur de neutre ou de phase de la ligne d'alimentation, extérieur à l'appareil 4, est destiné à être raccordé soit au terminal 1012a soit au terminal 1012c. De même, l'autre conducteur de phase ou de neutre de la ligne d'alimentation est destiné à être raccordé soit au terminal 1012b soit au terminal 1012d.

Le dispositif d'interconnexion électrique interne est ici modifié en conséquence.

La zone 1010' est réalisée de façon analogue.

Dans cet exemple, le boîtier 1008 est commun à l'appareil 1004 et au module 1006. La largeur de l'ensemble 1002, mesurée de façon analogue à la largeur L2, est ici égale à 36mm. De même, la largeur du module 1006 est ici égale à 18mm.

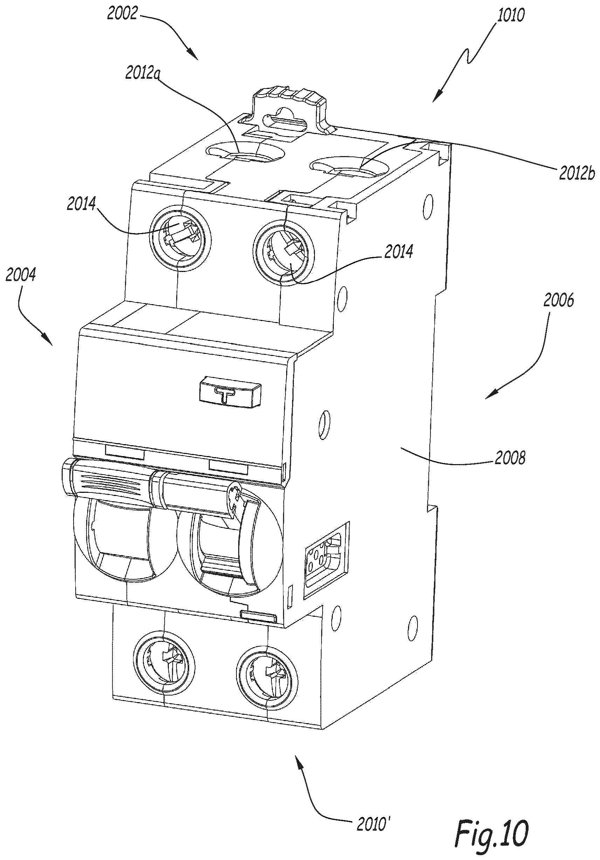

La figure 10 représente ensemble de protection 2002 selon un troisième mode de réalisation de l'invention. Les éléments du module de détection de ce mode de réalisation qui sont analogues à l'ensemble de protection 2 du premier mode de réalisation portent les mêmes références incrémentées de la valeur 2000. Ces éléments ne sont pas décrits en détail, dans la mesure où la description ci-dessus peut leur être transposée. En particulier, tout ce qui est décrit ci-dessus en référence au fonctionnement du module 6 et à ses composants 6' s'applique ici au module 2006.

L'ensemble 2002 diffère notamment de l'ensemble 2 par la forme et l'agencement des zones de raccordement 2010 et 2010'.

Ici, la zone 2010 comporte un terminal de raccordement 2012a disposé au niveau de l'appareil 4 et associé à une vis de fixation 1014, et un terminal de raccordement 1012b disposé au niveau du module 1006 et associés à une autre vis de fixation 1014.

La zone 2010' est réalisée de façon analogue.

En d'autres termes, l'ensemble 2002 est similaire à l'ensemble 1002, sauf que les terminaux 1012c et 1012d sont ici omis.

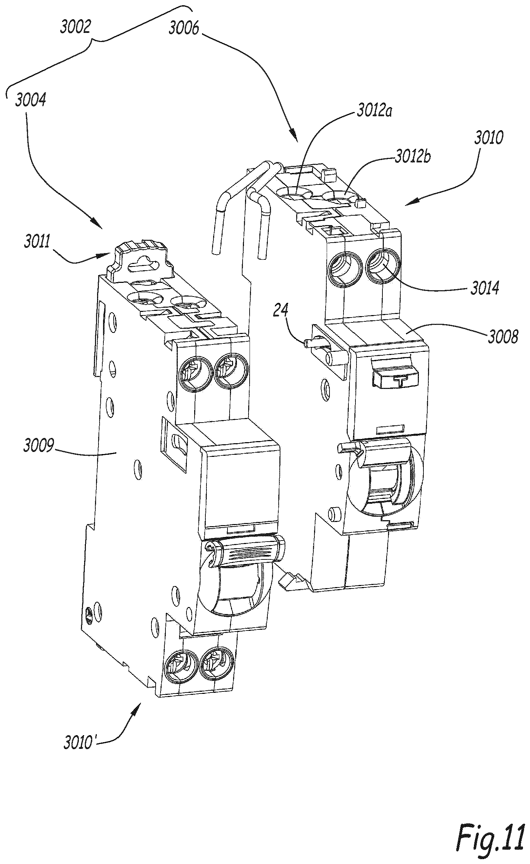

La figure 11 représente ensemble de protection 3002 selon un quatrième mode de réalisation de l'invention. Les éléments du module de détection de ce mode de réalisation qui sont analogues à l'ensemble de protection 2 du premier mode de réalisation portent les mêmes références incrémentées de la valeur 3000. Ces éléments ne sont pas décrits en détail, dans la mesure où la description ci-dessus peut leur être transposée. En particulier, tout ce qui est décrit ci-dessus en référence au fonctionnement du module 6 et à ses composants 6' s'applique ici au module 3006.

L'ensemble 3002 diffère notamment de l'ensemble 2 par le fait que le module 3006 et l'appareil 3004 sont dissociables l'un de l'autre. L'appareil 3004 comporte un boîtier additionnel 3009 qui est distinct du boîtier 3008 du module de détection 3006.

La largeur du module 3006 est ici égale à 18mm. De même, la largeur de l'appareil 3004 et ici égale à 18mm.

Dans cet exemple la forme et l'agencement des zones de raccordement 3010 et 3010' sont similaires à celle des zones 10 et 10', mis à part qu'ici, l'emplacement des zones 3010 et 3010' est décalé symétriquement par rapport à l'emplacement des zones 10 et 10'. Par exemple, alors que la zone 10 est disposée sur l'appareil 4 sur une face supérieure gauche de l'ensemble 2 et que la zone 10' est disposée sur le module 6 sur une face inférieure droite de l'ensemble 2, ici la zone 3010 est disposée sur le module 3006 sur une face supérieure droite de l'ensemble 3002 et la zone 3010' est disposée sur le module 3004 sur une face inférieure gauche de l'ensemble 3002.

Dans cet exemple illustratif, l'appareil 3004 comporte en outre une zone de raccordement 3011 supplémentaire. Cette zone 3011 n'est pas nécessairement utilisée pour raccorder l'ensemble 3002 sur l'installation électrique à protéger. En pratique, cette zone 3001 est recouverte d'un capot de protection pour empêcher à un opérateur d'y accéder lorsque l'ensemble 3002 est dans une configuration assemblée. Cette zone 3011 est ici présente à cause de l'aspect modulaire de l'ensemble 2. Comme le module 3006 et l'appareil 3004 sont dissociables l'un de l'autre, il est alors possible, comme ici, d'utiliser un appareil de coupure 3004 ordinaire apte à fonctionner indépendamment, dans d'autres utilisations que l'ensemble 2. Cette zone 3011 peut être omise.

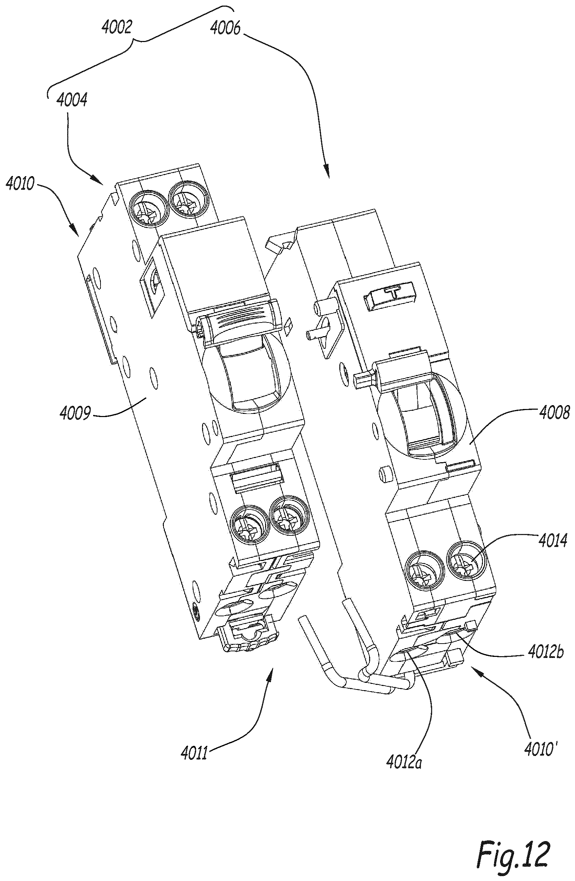

La figure 12 représente ensemble de protection 4002 selon un cinquième mode de réalisation de l'invention. Les éléments du module de détection de ce mode de réalisation qui sont analogues à l'ensemble de protection 2 du premier mode de réalisation portent les mêmes références incrémentées de la valeur 4000. Ces éléments ne sont pas décrits en détail, dans la mesure où la description ci-dessus peut leur être transposée. En particulier, tout ce qui est décrit ci-dessus en référence au fonctionnement du module 6 et à ses composants 6' s'applique ici au module 4006.

L'ensemble 4002 diffère notamment de l'ensemble 2 par la disposition des zones 4010 et 4010' ainsi que par le fait que le module 4006 et l'appareil 4004 sont dissociables l'un de l'autre. L'appareil 4004 comporte un boîtier additionnel 4009 qui est distinct du boîtier 4008 du module de détection 4006.

L'ensemble 4002 est notamment analogue à l'appareil 3002, mis à part que les zones 4010 et 4010' sont disposées en des emplacements opposés à ceux des zones 3010 et 3010', respectivement. Par exemple, ici, la zone 4010 est disposée sur une face inférieure du module 4006 au lieu d'être disposée sur une face supérieure, comme l'est la zone 3010 du module 3006. Il en va de même pour les zones 4010' et 4011, cette dernière étant analogue à la zone 3011 précédemment décrite.

La configuration particulière des zones de raccordement respectives des ensembles 1002, 2002, 3002 et 4002 permet de s'adapter aux normes et aux spécificités propres à certains marchés, ce qui facilite là encore l'utilisation de ces ensembles 1002, 2002, 3002 et 4002 sur des installations existantes, par exemple lors d'opérations de rétrofit.

Les modes de réalisation et les variantes envisagés ci-dessus peuvent être combinés entre eux pour générer de nouveaux modes de réalisation.

## Revendications

1. Module de détection (6; 1006 ; 2006 ; 3006 ; 4006) d'un défaut électrique pour un ensemble de protection électrique (2 ; 1002 ; 2002 ; 3002 ; 4002), ce module de détection comprenant :
- un boîtier (8; 1008 ; 2008 ; 3008 ; 4008) ;
- un premier conducteur de ligne (30) et un second conducteur de ligne (32), adaptés pour être connectés à des lignes d'alimentation électrique ;
- un premier tore de mesure (34), disposé autour du premier conducteur de ligne (30) et du second conducteur de ligne (32), pour mesurer un courant différentiel circulant entre les premier et second conducteurs de ligne (30, 32) ;
- un deuxième tore de mesure (36), disposé autour du premier conducteur de ligne (30), pour détecter un signal d'arc électrique circulant dans ce conducteur ;
- un relais électromécanique (42) de déclenchement ;
- un circuit électronique de traitement connecté aux premier et deuxième tores de mesure (34, 36) et configuré pour commuter le relais (42) en fonction du courant mesuré par les tores de mesure ;
ce module de détection étant **caractérisé en ce que** les premier et deuxième tores de mesure (34, 36) sont alignés entre eux de telle sorte que leurs axes longitudinaux respectifs (X34, X36) soient parallèles et décalés d'une distance inférieure à 10mm, **en ce que** le premier tore de mesure (34) présente une forme tubulaire allongée et permet un fonctionnement de la protection différentielle à propre courant en étant adapté pour, en cas de défaut différentiel entre les premier et deuxième conducteurs de ligne (30, 32), générer un signal de détection de défaut à partir de courants induits générés par les courants électriques qui circulent dans les conducteurs (30, 32) pour déclencher la commutation du relais (42).

2. Module de détection selon la revendication 1, **caractérisé en ce que** le rapport de la longueur (L34) du premier tore de mesure (34) sur le diamètre (D56) du premier tore de mesure est supérieur ou égal à 1, de préférence supérieur ou égal à 1,5.

3. Module de détection selon l'une quelconque des revendications précédentes, **caractérisé en ce que** le circuit électronique de traitement comporte au moins une carte électronique (38, 40), et **en ce que** le relais (42) présente une forme aplatie avec une épaisseur (E42) inférieure ou égale à 12mm, le relais (42) étant fixé sur ladite carte électronique (38, 40).

4. Module de détection selon l'une quelconque des revendications précédentes, **caractérisé en ce que** le circuit électronique de traitement comprend également une carte électronique additionnelle (38, 40) superposée avec l'autre carte électronique (38, 40), le relais (42) étant intercalé entre les cartes électroniques (38, 40) en étant placé au contact de ces cartes électroniques (38, 40).

5. Module de détection selon l'une quelconque des revendications précédentes, **caractérisé en ce que** la largeur du module de détection (6 ; 1006 ; 2006 ; 3006 ; 4006) est égale à 18mm.

6. Module de détection selon l'une quelconque des revendications précédentes, **caractérisé en ce que** la longueur (L34) du premier tore de mesure (34), mesurée selon l'axe longitudinal (X34), est comprise entre 15mm et 50mm.

7. Module de détection selon l'une quelconque des revendications précédentes, **caractérisé en ce que** le premier tore de mesure (34) comporte, disposés de façon coaxiale, un passage central (50) creux, un cœur magnétique (52) torique entourant le passage central creux, un premier boîtier (54) qui entoure le cœur magnétique, une bobine (56) formée par un enroulement d'un fil conducteur autour du premier boîtier (54), et un deuxième boîtier (58) qui recouvre au moins partiellement la bobine.

8. Module de détection selon la revendication 6, **caractérisé en ce que** le premier tore de mesure (34) est connecté à une carte électronique (40) du circuit électronique de traitement et **en ce que** le deuxième boîtier (58) du premier tore de mesure (34) comporte une patte de maintien (76) en forme de languette, ladite carte électronique (40) comportant un évidement (78) de forme complémentaire à la patte de maintien (76), la patte de maintien (76) étant reçue dans cet évidement (78).

9. Ensemble de protection électrique (2 ; 1002 ; 2002 ; 3002 ; 4002) comprenant un appareil de coupure (4 ; 1004 ; 2004 ; 3004 ; 4004) d'un courant électrique et un module de détection (6 ; 1006 ; 2006 ; 3006 ; 4006) d'au moins un défaut électrique, ce module de détection étant associé à l'appareil de coupure (4 ; 1004 ; 2004 ; 3004 ; 4004) et étant destiné à commander le déclenchement de cet appareil de coupure, cet ensemble de protection électrique (2 ; 1002 ; 2002 ; 3002 ; 4002) étant **caractérisé en ce que** le module de détection (6 ; 1006 ; 2006 ; 3006 ; 4006) est selon l'une quelconque des revendications précédentes.

10. Ensemble de protection électrique (2 ; 1002 ; 2002) selon la revendication 9, **caractérisé en ce que** le boîtier (8; 1008 ; 2008) est commun au module de détection (6 ; 1006 ; 2006) et à l'appareil de coupure (4 ; 1004 ; 2004).

11. Ensemble de protection électrique (3002 ; 4002) selon la revendication 9, **caractérisé en ce que** l'appareil de coupure (3004 ; 4004) comporte un boîtier additionnel (3009 ; 4009) distinct du boîtier (3008 ; 4008) du module de détection (3006 ; 4006), l'appareil de coupure (3004 ; 4004) et le module de détection (3006 ; 4006) étant dissociables l'un de l'autre.

## Patentansprüche

1. Modul zur Detektion (6; 1006; 2006; 3006; 4006) einer elektrischen Störung für eine elektrische Schutzanordnung (2; 1002; 2002; 3002; 4002), wobei dieses Modul zur Detektion Folgendes umfasst:
- ein Gehäuse (8; 1008; 2008; 3008; 4008);
- einen ersten Linienleiter (30) und einen zweiten Linienleiter (32), die ausgelegt sind, um mit elektrischen Versorgungsleitungen verbunden zu sein;
- einen ersten Messtorus (34), der um den ersten Linienleiter (30) und den zweiten Linienleiter (32) angeordnet ist, um einen Differenzstrom zu messen, der zwischen dem ersten und dem zweiten Linienleiter (30, 32) zirkuliert;
- einen zweiten Messtorus (36), der um den ersten Linienleiter (30) angeordnet ist, um ein Lichtbogensignal zu detektieren, das in diesem Leiter zirkuliert;
- ein elektronmechanisches Relais (42) zum Auslösen;
- eine elektronische Verarbeitungsschaltung, die mit dem ersten und zweiten Messtorus (34, 36) verbunden und konfiguriert ist, um das Relais (42) je nach dem Strom, der von den Messtori gemessen wird, umzuwandeln;
wobei dieses Modul zur Detektion **dadurch gekennzeichnet ist, dass** der erste und zweite Messtorus (34, 36) untereinander derart ausgefluchtet sind, dass ihre jeweiligen Längsachsen (X34, X36) parallel und um einen Abstand von weniger als 10 mm versetzt sind, dadurch, dass der erste Messtorus (34) eine verlängerte Rohrform aufweist und eine Funktion des Differentialschutzes mit eigenem Strom ermöglicht, indem sie ausgelegt ist, um im Fall einer Differentialstörung zwischen dem ersten und zweiten Linienleiter (30, 32) ein Signal zur Detektion der Störung ausgehend von induzierten Strömen zu erzeugen, die von den elektrischen Strömen erzeugt wurden, die in den Leitern (30, 32) zirkulieren, um die Umwandlung des Relais (42) auszulösen.

2. Modul zur Detektion nach Anspruch 1, **dadurch gekennzeichnet, dass** die Beziehung zwischen der Länge (L34) des ersten Messtorus (34) zum Durchmesser (D56) des ersten Messtorus grösser als oder gleich wie 1, vorzugsweise grösser als oder gleich wie 1,5 ist.

3. Modul zur Detektion nach einem der vorhergehenden Ansprüche, **dadurch gekennzeichnet, dass** die elektronische Verarbeitungsschaltung mindestens eine elektronische Karte (38, 40) umfasst, und dadurch, dass das Relais (42) eine abgeflachte Form mit einer Dicke (E42) aufweist, die kleiner als oder gleich wie 12 mm ist, wobei das Relais (42) auf der elektronischen Karte (38, 40) fixiert ist.

4. Modul zur Detektion nach einem der vorhergehenden Ansprüche, **dadurch gekennzeichnet, dass** die elektronische Verarbeitungsschaltung auch eine zusätzliche elektronische Karte (38, 40) umfasst, die von der anderen elektronischen Karte (38, 40) überlagert ist, wobei das Relais (42) zwischen die elektronischen Karten (38, 40) eingeschoben ist, indem es in Kontakt mit diesen elektronischen Karten (38, 40) platziert ist.

5. Modul zur Detektion nach einem der vorhergehenden Ansprüche, **dadurch gekennzeichnet, dass** die Breite des Moduls zur Detektion (6; 1006; 2006; 3006; 4006) gleich wie 18 mm ist.

6. Modul zur Detektion nach einem der vorhergehenden Ansprüche, **dadurch gekennzeichnet, dass** die Länge (L34) des ersten Messtorus (34), gemessen entlang der Längsachse (X34), im Bereich zwischen 15 mm und 50 mm liegt.

7. Modul zur Detektion nach einem der vorhergehenden Ansprüche, **dadurch gekennzeichnet, dass** der erste Messtorus (34), angeordnet auf koaxiale Weise, einen hohlen zentralen Durchgang (50) umfasst, wobei ein torischer magnetischer Kern (52) den hohlen zentralen Durchgang umgibt, ein erstes Gehäuse (54), das den magnetischen Kern umgibt, eine Spule (56), die durch eine Wicklung eines leitenden Drahts um das erste Gehäuse (54) gebildet ist, und ein zweites Gehäuse (58), das die Spule mindestens teilweise abdeckt.

8. Modul zur Detektion nach Anspruch 6, **dadurch gekennzeichnet, dass** der erste Messtorus (34) mit einer elektronischen Karte (40) der elektronischen Verarbeitungsschaltung verbunden ist, und dadurch, dass das zweite Gehäuse (58) des ersten Messtorus (34) eine Befestigungsklemme (76) in Form einer Lasche umfasst, wobei die elektronische Karte (40) eine Aussparung (78) mit komplementärer Form zur Befestigungsklemme (76) umfasst, wobei die Befestigungsklemme (76) in dieser Aussparung (78) aufgenommen wird.

9. Elektrische Schutzanordnung (2; 1002; 2002; 3002; 4002), umfassend ein Schaltgerät (4; 1004; 2004; 3004; 4004) eines elektrischen Stroms und ein Modul zur Detektion (6; 1006; 2006; 3006; 4006) mindestens einer elektrischen Störung, wobei dieses Modul zur Detektion dem Schaltgerät (4; 1004; 2004; 3004; 4004) zugewiesen ist und ausgelegt ist, das Auslösen dieses Schaltgeräts zu steuern, wobei diese elektrische Schutzanordnung (2; 1002; 2002; 3002; 4002) **dadurch gekennzeichnet ist, dass** das Modul zur Detektion (6; 1006; 2006; 3006; 4006) nach einem der vorhergehenden Ansprüche ist.

10. Elektrische Schutzanordnung (2; 1002; 2002) nach Anspruch 9, **dadurch gekennzeichnet, dass** das Gehäuse (8; 1008; 2008) dem Modul zur Detektion (6; 1006; 2006) und dem Schaltgerät (4; 1004; 2004) gemeinsam ist.

11. Elektrische Schutzanordnung (3002; 4002) nach Anspruch 9, **dadurch gekennzeichnet, dass** das Schaltgerät (3004; 4004) ein zusätzliches Gehäuse (3009; 4009) umfasst, das verschieden vom Gehäuse (3008; 4008) des Moduls zur Detektion (3006; 4006) ist, wobei das Schaltgerät (3004; 4004) und das Modul zur Detektion (3006; 4006) voneinander trennbar sind.

## Claims

1. A module (6; 1006; 2006; 3006; 4006) for detecting an electrical fault for an electrical protection assembly (2; 1002; 2002; 3002; 4002), this detection module comprising:
- a housing (8; 1008; 2008; 3008; 4008);
- a first line conductor (30) and a second line conductor (32), suitable for being connected to power supply lines;
- a first measurement toroid (34), positioned around the first line conductor (30) and around the second line conductor (32), for measuring a differential current flowing between the first and second line conductors (30, 32);
- a second measurement toroid (36), positioned around the first line conductor (30), for detecting an electric arc signal flowing in this conductor;
- an electromechanical tripping relay (42);
- an electronic processing circuit connected to the first and second measurement toroids (34, 36) and configured to switch the relay (42) as a function of the current measured by the measurement toroids;
this detection module being **characterized in that** the first and second measurement toroids (34, 36) are aligned with one another so that their respective longitudinal axes (X34, X36) are parallel and offset by a distance of less than 10 mm, **in that** the first measurement toroid (34) assumes the shape of an elongated tube and allows the differential protection to operate with its own current while being suitable, in the case of a differential fault between the first and second line conductors (30, 32), for generating a fault detection signal from induced currents generated by the electrical currents circulating in the conductors (30, 32) to trigger switching of the relay (42).

2. The detection module according to claim 1, wherein the ratio of the length (L34) of the first measurement toroid (34) to the diameter (D56) of the first measurement toroid is greater than or equal to 1, preferably greater than or equal to 1.5.

3. The detection module according to any one of the preceding claims, **characterized in that** the electronic processing circuit comprises at least one electronic card (38, 40), and **in that** the relay (42) has a flattened shape with a thickness (E42) less than or equal to 12 mm, the relay (42) being secured to said electronic card (38, 40).

4. The detection module according to any one of the preceding claims, **characterized in that** the electronic processing circuit also comprises a first electronic card (38, 40) superimposed on the other electronic card (38, 40), the relay (42) being intercalated between the electronic cards (38, 40) by being placed in contact with these electronic cards (38, 40).

5. The detection module according to any one of the preceding claims, **characterized in that** the width of the detection module (6; 1006; 2006; 3006; 4006) is equal to 18 mm.

6. The detection module according to any one of the preceding claims, **characterized in that** the length (L34) of the first measurement toroid (34), measured along the longitudinal axis (X34), is between 15 mm and 50 mm.

7. The detection module according to any one of the preceding claims, **characterized in that** the first measurement toroid (34) comprises, arranged in coaxial manner, a hollow central passage (50), a toroidal magnetic core (52) surrounding the hollow central passage, a first housing (54) that surrounds the magnetic core, a coil (56) formed by a winding of a conductive wire around the first housing (54), and a second housing (58) that covers the coil at least partly.

8. The detection module according to claim 6, **characterized in that** the first measurement toroid (34) is connected to an electronic card (40) of the electronic processing circuit and **in that** the second housing (58) of the first measurement toroid (34) comprises a support lug (76) in the form of a tab, said electronic card (40) having a cavity (78) of complementary shape to the support lug (76), the support lug (76) being received in this cavity (78).

9. An electrical protection assembly (2; 1002; 2002; 3002; 4002) comprising a breaking device (4; 1004; 2004; 3004; 4004) for an electrical current and a detection module (6; 1006; 2006; 3006; 4006) for at least one electrical fault, this detection module being associated with the breaking device (4; 1004; 2004; 3004; 4004) and being designed to control the tripping of this breaking device, this electrical protection assembly (2; 1002; 2002; 3002; 4002) being **characterized in that** the detection module (6; 1006; 2006; 3006; 4006) is according to any one of the preceding claims.

10. The electrical protection assembly (2; 1002; 2002) according to claim 9, **characterized in that** the housing (8; 1008; 2008) is common to the detection module (6; 1006; 2006) and to the breaking device (4; 1004; 2004).

11. The electrical protection assembly (3002; 4002) according to claim 9, **characterized in that** the breaking device (3004; 4004) comprises an additional housing (3009; 4009) distinct from the housing (3008; 4008) of the detection module (3006; 4006), the breaking device (3004; 4004) and the detection module (3006; 4006) being separable from each other.
